# FASCICULE DE BREVET EUROPEEN

(11) **EP 2 267 893 B1**
(45) Date de publication et mention de la délivrance du brevet: **14.11.2012**
(21) Numéro de dépôt: 10165137.0
(22) Date de dépôt: 07.06.2010
(51) Int. Cl.: H03H 3/007, H03H 9/24

(54) **Résonateur à ondes de volume avec des cavités partiellement remplies**
Volumenwellenresonator mit teilweise gefüllten Kavitäten
Bulk acoustic wave resonator with partially filled cavities

(30) Priorité: 08.06.2009 FR 0953773
(43) Date de publication de la demande: 29.12.2010
(73) Titulaire: STmicroelectronics SA, 92120 Montrouge (FR); Commissariat à l'Énergie Atomique et aux Énergies Alternatives, 75015 Paris (FR)
(72) Inventeur: Casset, Fabrice, 38570 Tencin (FR); Durand, Cédric, 38400 Saint Martin d'Hères (FR)
(74) Mandataire: de Beaumont, Michel

(56) Documents cités:
- US-A1- 2007 001 783
- US-A1- 2007 296 527
- US-A1- 2008 284 544
- US-A1- 2009 153 267
- BEDAIR S S ET AL: "Polymer wicking to mass load cantilevers for chemical gravimetric sensors" SOLID-STATE SENSORS, ACTUATORS AND MICROSYSTEMS, 2005. DIGEST OF TECHN ICAL PAPERS. TRANSDUCERS '05. THE 13TH INTERNATIONAL CONFERENCE ON SEOUL, KOREA JUNE 5-9, 2005, PISCATAWAY, NJ, USA,IEEE, vol. 2, 5 juin 2005 (2005-06-05), pages 2035-2039, XP010828770 ISBN: 978-0-7803-8994-6
- COURCIMAULT C G ET AL: "High-Q mechanical tuning of MEMS resonators using a metal deposition - annealing technique", SOLID-STATE SENSORS, ACTUATORS AND MICROSYSTEMS, 2005. DIGEST OF TECHN ICAL PAPERS. TRANSDUCERS '05. THE 13TH INTERNATIONAL CONFERENCE ON SEOUL, KOREA JUNE 5-9, 2005, PISCATAWAY, NJ, USA,IEEE, vol. 1, 5 June 2005 (2005-06-05), pages 875-878, XP010828057, DOI: 10.1109/SENSOR.2005.1496557 ISBN: 978-0-7803-8994-6

## Description

### Domaine de l'invention

La présente demande concerne des structures et des procédés de fabrication de résonateurs à ondes de volume.

### Exposé de l'art antérieur

Pour réaliser des bases de temps, de nombreux circuits utilisent des oscillateurs à quartz. De tels oscillateurs ont un facteur de qualité élevé de l'ordre de 100 000 et une fréquence de résonance stable en température. Ils présentent toutefois l'inconvénient d'avoir une plage de fréquences de résonance limitée à des valeurs inférieures à la centaine de mégahertz, typiquement 30 MHz. De plus, ils sont difficilement intégrables dans un même ensemble que des circuits électroniques formés dans un substrat semiconducteur.

Pour atteindre des fréquences plus élevées et réduire les niveaux de consommation, des théoriciens ont proposé de remplacer les oscillateurs à quartz par des microsystèmes électromécaniques (MEMS) par exemple des résonateurs à ondes de volume (bulk mode resonators) .

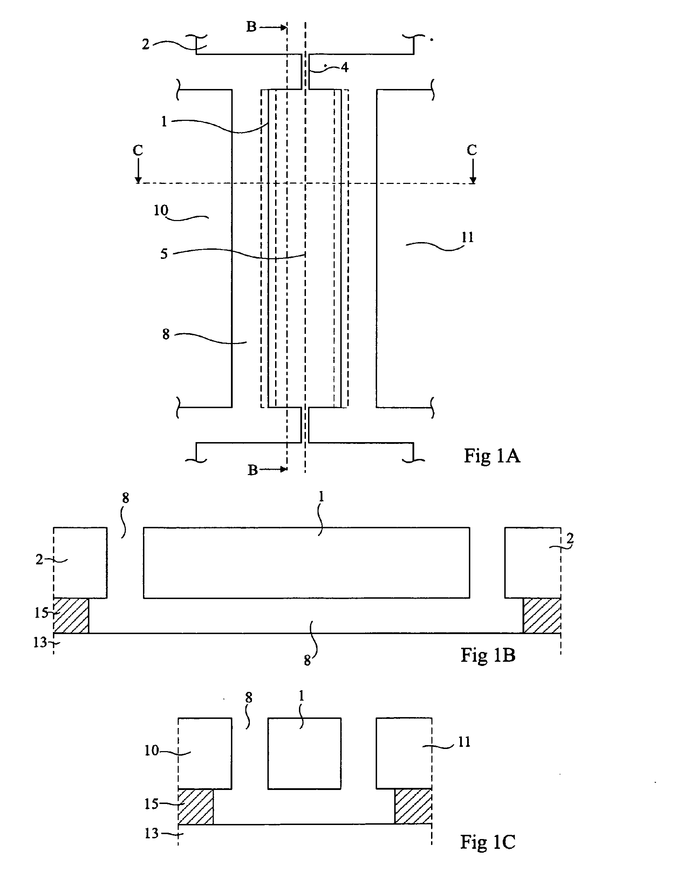

La figure 1A est une vue de dessus partielle et schématique d'un résonateur à ondes de volume. Les figures 1B et 1C sont des vues en coupe selon des plans B-B et C-C.

Le résonateur comporte un élément résonant 1 constitué généralement d'une portion d'un matériau semiconducteur monocristallin ou polycristallin par exemple en forme de barreau de section rectangulaire. L'élément 1 est fixé à au moins une zone d'ancrage 2 par des bras 4. Les bras 4 sont disposés de façon à contacter l'élément 1 au niveau de noeuds de vibration de celui-ci. Les bras 4 sont alignés le long d'une ligne neutre de vibration 5 de l'élément 1 illustrée en traits pointillés.

En dehors de sa liaison avec les bras 4, l'élément 1 est entouré d'un intervalle vide 8. Deux électrodes 10 et 11 sont placées symétriquement en regard de l'élément 1 de part et d'autre de la ligne neutre 5.

Le plan de coupe B-B est parallèle à la ligne neutre 5 et ne passe pas par les bras 4. Le plan de coupe C-C est perpendiculaire au plan B-B et coupe l'élément 1 et les électrodes 10 et 11.

Comme l'illustrent les figures 1B et 1C, le résonateur est formé dans une couche mince de silicium monocristallin reposant sur une plaquette de silicium 13 avec interposition d'une couche isolante 15. La partie de l'intervalle 8 séparant l'élément 1 du support 13 résulte du retrait partiel de l'isolant 15. L'élément 1, les ancrages 2 et les électrodes 10 et 11 sont réalisés dans la couche mince.

Le fonctionnement du résonateur est le suivant. L'élément 1 est au moins partiellement en un matériau conducteur mis à un premier potentiel et les électrodes 10 et 11 sont mises à un deuxième potentiel. La différence de potentiel entre l'élément 1 et les électrodes 10 et 11 crée une force électrostatique qui provoque une déformation de l'élément 1. L'élément 1 entre alors dans un mode de vibration en volume à sa fréquence de résonance, ce qui correspond à une oscillation d'ondes de volume autour de la ligne neutre centrale 5 de l'élément 1. La déformation de l'élément 1 provoque une variation de la capacité du condensateur constitué par l'élément 1 et les électrodes 10 et 11. Cette variation de capacité peut être détectée au niveau de l'électrode 10 ou 11.

En théorie, il est ainsi possible d'obtenir des résonateurs ayant des fréquences de résonance qui varient dans une plage allant de 10 à 300 MHz jusqu'à 1,5 à 3 GHz.

De tels résonateurs présentent les avantages théoriques d'avoir des niveaux de consommation inférieurs à ceux des oscillateurs à quartz et d'être facilement intégrables.

En pratique, l'utilisation de tels résonateurs à ondes de volume notamment en tant que bases de temps se heurte à diverses limitations. En particulier, on observe des variations incontrôlables de la fréquence réelle de résonance par rapport à la fréquence nominale visée. Les variations observées sont typiquement comprises dans une plage de 5 à 10 % de la valeur de la fréquence visée, aléatoirement par défaut ou par excès.

Des résonateurs ayant des fréquences élevées supérieures à la centaine de mégahertz sont particulièrement recherchés pour des bases de temps placées dans des appareils portables tels que des téléphones ou des ordinateurs. Dans de tels appareils, une dérive de la fréquence nominale est inacceptable.

Diverses solutions ont été proposées pour pallier la dérive de la fréquence réelle d'un résonateur à ondes de volume par rapport à une fréquence visée.

Une solution consiste à effectuer une correction électrique de la fréquence, notamment en modifiant la tension de polarisation de l'élément 1. Cette solution ne permet de corriger la valeur de la fréquence que de quelques ppm/V. Cela est insuffisant pour corriger les 5 à 10 % de dérive observés ou requiert des niveaux de polarisation irréalistes pour des dispositifs embarqués fonctionnant sur batterie.

Une autre solution consiste à utiliser la propriété de variation de la fréquence avec la température. Ainsi, un filament est déposé sur l'élément résonant de façon à modifier - diminuer - la fréquence. Une telle solution n'est pas satisfaisante car le chauffage du filament accroît la consommation du dispositif, ce qui n'est pas souhaitable dans le cas de dispositifs fonctionnant sur batterie.

D'autres solutions consistent à modifier la masse de l'élément 1.

Pour diminuer cette masse, on peut vaporiser une partie du corps de l'élément 1 au moyen d'un laser. Cette correction est relativement complexe à mettre en oeuvre car elle impose le recours à un équipement dédié qui ne fait pas partie des dispositifs couramment utilisés dans la fabrication des systèmes MEMS. La complexité et le coût accrus de cette solution la rendent inapplicable dans un environnement industriel.

Pour augmenter la masse, on a proposé de soumettre l'élément 1 à un bombardement ionique. Toutefois, cette solution manque de souplesse car elle doit impérativement être mise en oeuvre avant la mise en boîtier du dispositif.

Toutes ces solutions se heurtent à l'impossibilité de prévoir l'apparition et l'étendue de la dérive qui est attribuable au moins en grande partie à la non-réalisation de conditions nominales et à une non-répétabilité des conditions de mise en oeuvre du procédé de fabrication décrit précédemment. En particulier, lors de la définition de l'élément résonant 1 par gravure de la couche mince sur isolant, d'un lot à un autre, peuvent se produire des fluctuations de la composition du milieu de gravure ou du temps d'exposition à celui-ci d' où il résulte une modification des dimensions de l'élément 1. Ces aléas et d'autres qui semblaient négligeables se combinent pour modifier la fréquence qui dépend essentiellement des dimensions, de la densité et du module d'Young de l'élément 1.

Les documents US 2007/296527, US 2008/284544, US 2009/153267 et US 2007/001783 et la publication intitulée "High-Q mechanical tuning of MEMS resonators using a metal déposition - annealing technique" (Solid-State Sensors, Actuators and Microsystems, 2005, volume 1, 5 juin 2005, pages 875-878) aux noms de Christophe Courcimault et Mark Allen portent sur la fabrication de résonateurs et la publication intitulée "Polymer wicking to mass load cantilevers for chemical gravimetric sensors" (Solid-State Sensors, Actuators and Microsystems, 2005, volume 2, 5 juin 2005, pages 2035-2039) aux noms de Sarah Bedair et Gary Fedder porte sur un capteur gravimétrique.

### Résumé de l'invention

La présente invention vise à proposer des structures de résonateurs à ondes de volume et des procédés de fabrication de ceux-ci qui pallient au moins en partie les inconvénients des procédés et dispositifs connus.

En particulier, la présente invention vise à proposer des procédés de fabrication de tels résonateurs tels que la fréquence d'oscillation du résonateur soit égale à une valeur nominale recherchée à mieux que 0,01 à 1 %.

De façon générale, les inventeurs proposent d'introduire volontairement une distorsion, à savoir une augmentation de la fréquence en diminuant la masse et les dimensions de l'élément résonant. Ensuite, la fréquence réelle est mesurée et comparée à la fréquence nominale. L'éventuel écart observé est alors compensé en accroissant de nouveau la masse et les dimensions de l'élément résonant.

Ainsi, la présente invention prévoit un procédé de formation d'un résonateur à ondes de volume comprenant un élément résonant, l'élément résonant étant constitué au moins en partie d'un corps constitué au moins en partie d'un premier matériau conducteur, le corps comportant des cavités débouchantes, ce procédé comprenant les étapes suivante :
mesure de la fréquence du résonateur ; et
remplissage au moins partiel desdites cavités.

Selon la présente invention, le premier matériau est poreux, au moins certaines des cavités étant constituées par des pores débouchants.

Selon un mode de réalisation de la présente invention, au moins certaines des cavités débouchantes sont des puits creusés au moins dans une partie de l'épaisseur de l'élément résonant.

Selon un mode de réalisation de la présente invention, l'étape de remplissage est effectuée après la mise en place d'un capot.

Selon un mode de réalisation de la présente invention, le matériau de remplissage des cavités est choisi parmi le silicium, le germanium, le silicium-germanium, le ruthénium, l'iridium, le platine, le séléniure de zinc, l'oxyde de silicium, les oxydes d'aluminium, de titane, de zinc, d'hafnium, le nitrure de silicium, les nitrures de titane, de tantale, de tungstène, de niobium, l'oxynitrure de silicium et le sulfure de zinc.

Selon un mode de réalisation de la présente invention, le procédé comprend en outre une étape de formation, dans le corps, de colonnes d'un matériau ayant un module d'Young dont le coefficient de température est d'un signe opposé à celui du premier matériau.

La présente invention prévoit également un résonateur comprenant un élément résonant comportant un corps constitué au moins en partie d'un premier matériau conducteur, le corps comportant des cavités débouchantes, les cavités étant au moins partiellement remplies d'un second matériau.

Selon la présente invention, le résonateur est un résonateur à ondes de volume.

Selon la présente invention, le premier matériau est poreux, au moins une partie des cavités étant constituée de pores.

Selon un mode de réalisation de la présente invention, le corps comporte des colonnes d'un matériau dont le coefficient de variation du module d'Young en fonction de la température est du signe opposé à celui du premier matériau.

### Brève description des dessins

Ces objets, caractéristiques et avantages, ainsi que d'autres seront exposés en détail dans la description suivante d'exemples de réalisation faite à titre non-limitatif en relation avec les figures jointes parmi lesquelles :
les figures 1A, 1B et 1C illustrent un résonateur à ondes de volume connu ;
les figures 2A à 2C sont des vues en coupe partielles et schématiques qui illustrent des premières étapes successives d'un procédé de fabrication d'un résonateur à ondes de volume selon un mode de réalisation de la présente invention ;
la figure 3 est une vue de dessus du résonateur de la figure 2C ;
la figure 4 est une vue en coupe selon le plan C-C de la figure 3 ;
les figures 5A et 5B sont des vues en coupe partielles et schématiques qui illustrent des secondes étapes successives d'un procédé de fabrication d'un résonateur à ondes de volume selon un mode de réalisation de la présente invention ; et
les figures 6A à 6C sont des vues en coupe partielles et schématiques qui illustrent des secondes étapes successives d'un procédé de fabrication d'un résonateur à ondes de volume selon un autre mode de réalisation de la présente invention.

Par souci de clarté, comme cela est habituel dans la représentation des microsystèmes, les diverses figures ne sont pas tracées à l'échelle.

### Description détaillée

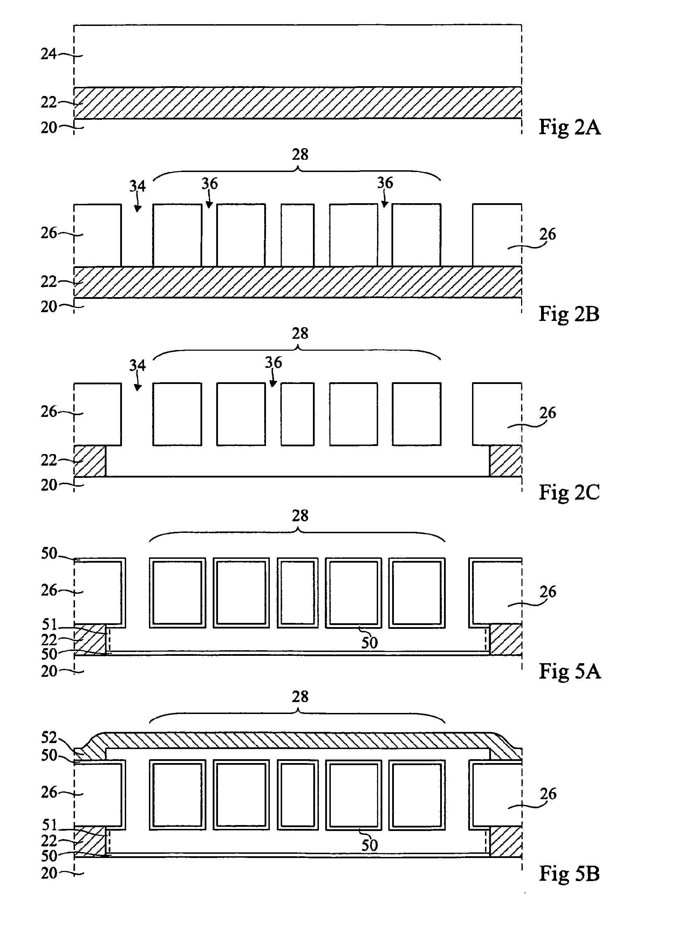

Les figures 2A à 2C sont des vues en coupe selon un même plan de coupe que la figure 1B qui illustrent à titre d'exemple des premières étapes d'un procédé de fabrication d'un résonateur à ondes de volume.

Comme l'illustre la figure 2A, on part d'une tranche semiconductrice du type silicium sur isolant dans laquelle un isolant 22 sépare une plaquette 20 d'un matériau semiconducteur d'une couche mince monocristalline 24 d'un autre matériau semiconducteur dopé pour être conducteur.

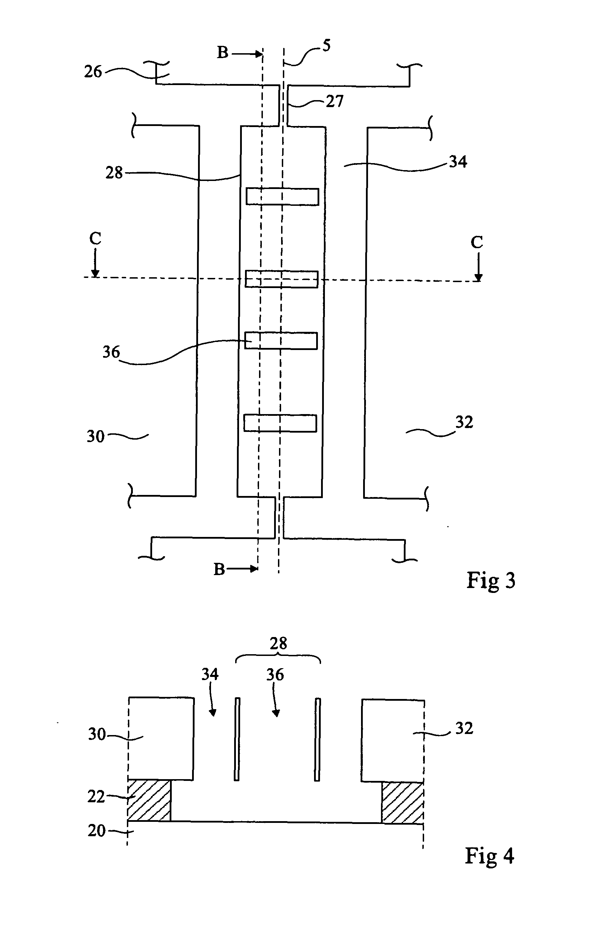

Comme l'illustre la figure 2B, on commence par définir dans la couche 24 les contours de zones d'ancrage 26, d'un élément résonant 28 et d'électrodes (30 et 32, figure 3) en creusant des tranchées 34.

Selon un mode de réalisation, dans la partie de la couche 24 destinée à constituer l'élément résonant 28, on creuse également des cavités 36. Les cavités 36 sont débouchantes, c'est-à-dire qu'elles comportent une ouverture sur une surface de l'élément résonant 28.

Selon un mode de réalisation, comme cela est représenté, les cavités 36 sont traversantes. Les tranchées 34 et les cavités 36 sont alors formées dans toute l'épaisseur de la couche 24 jusqu'à l'isolant 22. Les tranchées 34 et les cavités 36 peuvent être formées en utilisant un même masque.

Comme l'illustre la figure 2C, la couche 22 est retirée ce qui permet de libérer l'élément résonant 28 du résonateur. Lors de ce retrait, l'isolant enterré 22 est maintenu au moins partiellement sous les électrodes 30 et 32. L'élément 28 peut alors vibrer dans l'espace vide défini par les tranchées 34 et le retrait de l'isolant 22.

Comme l'illustrent la vue en coupe de la figure 2C, la vue de dessus de la figure 3 ainsi que la vue en coupe de la figure 4, les cavités 36 sont réparties de façon homogène dans l'élément 28. De préférence, les cavités 36 sont exclues d'une région périphérique de l'élément 28. Chaque cavité 36 s'étend perpendiculairement à la ligne neutre 5 qu'elle traverse. A titre de variante non représentée, chaque cavité 36 peut être subdivisée en une pluralité de cavités. Les cavités 36 pourront aussi être exclues d'une zone médiane qui s'étend symétriquement autour de la ligne neutre 5. Les cavités 36 sont alors de préférence formées symétriquement de part et d'autre de la zone médiane.

On a considéré en relation avec la figure 2B que les cavités 36 sont formées en même temps ou immédiatement après les tranchées 34. On notera toutefois que les cavités 36 peuvent être creusées à un stade ultérieur, notamment lorsque les cavités 36 ne traversent pas toute l'épaisseur de la couche 24. Par exemple, les cavités 36 peuvent être creusées après la formation dans toute l'épaisseur de la couche mince 24, dans la zone de formation de l'élément 28, de colonnes d'un matériau ayant un module d'Young dont le coefficient TCE de variation avec la température est du signe opposé à celui du matériau constituant la couche 24.

Selon un mode de réalisation, le matériau constituant la couche mince 24 est un matériau poreux dont les pores et la formation spécifique de cavités 36 décrite en relation avec la figure 2B n'est pas mise en oeuvre. Les cavités 36 peuvent alors être constituées uniquement par les pores du matériau. Comme cela a été précisé précédemment, les cavités 36, donc les pores, doivent être ouverts sur une surface de l'élément 28. Selon un mode de réalisation, les pores traversent toute l'épaisseur de la couche 24.

Dans la suite de la description, on décrira des secondes étapes d'un procédé de fabrication d'un résonateur à ondes de volume. Ces secondes étapes sont mises en oeuvre à partir d'une structure similaire à celle des figures 2C, 3 et 4, c'est-à-dire une structure dans laquelle l'élément résonant 28 comporte des cavités débouchantes 36, que ces cavités 36 traversent ou non toute l'épaisseur de l'élément 28 et/ou qu'elles résultent du creusement de la couche mince 24 ou de la présence de pores ou encore d'une combinaison des deux.

Selon un mode de réalisation, les secondes étapes commencent par un test de mesure de la fréquence de résonance de l'élément 28. Un tel test est déjà couramment mis en oeuvre aux fins d'écarter les dispositifs présentant une dérive de la fréquence supérieure à un seuil donné et ne requiert pas d'outillage spécifique supplémentaire. Ce test permet de déterminer l'écart de la fréquence réelle par rapport à la fréquence visée.

Selon un mode de réalisation décrit en relation avec les vues en coupe des figures 5A et 5B, l'étape de test est suivie de la formation d'une couche mince 50 sur les portions apparentes de la couche 24, en particulier sur les parois des cavités débouchantes 36 et autour de l'élément 28. Si ce dépôt est conforme, il conduit à la formation d'une portion 51 représentée en pointillés de la couche 50 sur les parties apparentes verticales de la couche isolante 22. Ainsi, si le matériau de la couche 50 est conducteur, le mode de dépôt sera choisi de façon à éviter la formation des portions 51 pour éviter tout court-circuit. Par exemple, si le corps est en un matériau semiconducteur, la couche 50 sera constituée d'un semiconducteur déposé par épitaxie sélective uniquement sur les portions semiconductrices et pas sur les portions isolantes 22.

Comme l'illustre la figure 5A, selon un mode de réalisation, les cavités 36 ne sont remplies que partiellement par la croissance de la couche 50 sur leurs parois.

Selon un autre mode de réalisation non représenté, les cavités 36 sont totalement remplies par la croissance de la couche 50. Le remplissage est effectué de façon à ce qu'aucune bulle d'air ne reste emprisonnée.

La nature et l'épaisseur de la couche 50 sont choisies en fonction du résultat du test de mesure de l'écart de la fréquence de façon à combiner l'effet d'accroissement de la masse et des dimensions de l'élément 28 ainsi qu'une éventuelle variation du module de Young de façon à atteindre la valeur de fréquence visée.

Ensuite, le procédé continue comme l'illustre la vue en coupe de la figure 5B par des étapes de formation d'un capot 52 et la formation de contacts (non représentés).

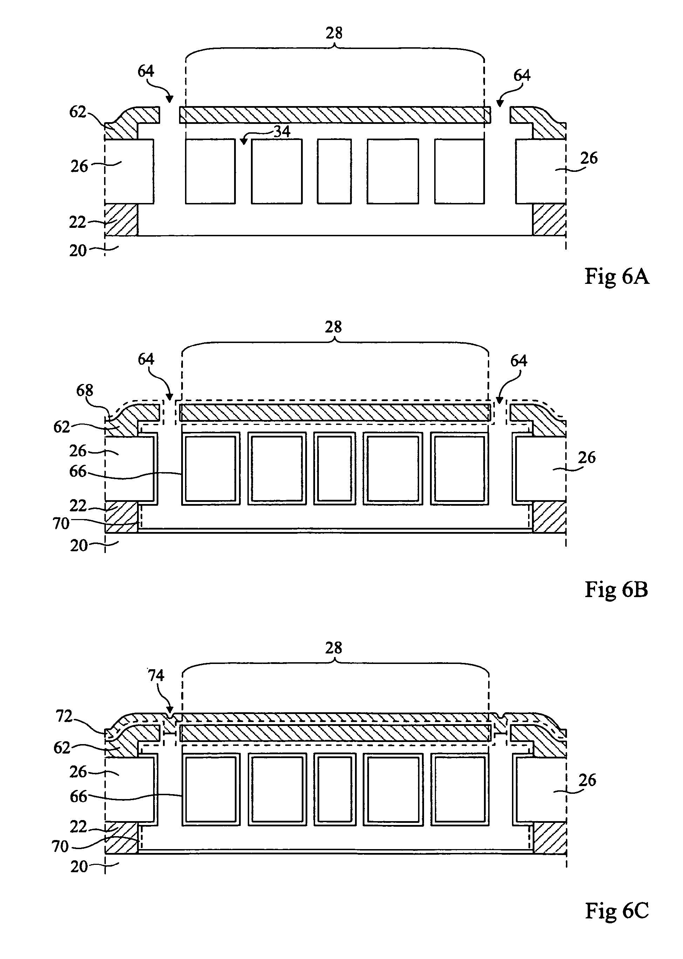

Selon un autre mode de réalisation, les secondes étapes précédemment décrites en relation avec les figures 5A et 5B sont remplacées par les secondes étapes décrites en relation avec les vues en coupe des figures 6A, 6B et 6C.

Selon un mode de réalisation, les secondes étapes commencent de nouveau par un test de mesure de la fréquence réelle du résonateur et par la détermination de la dérive de celle-ci par rapport à la fréquence visée.

Comme l'illustre la figure 6A, le résonateur comportant l'élément 28 traversé au moins partiellement par les cavités 36 est ensuite muni d'un capot 62. Des ouvertures 64 sont formées dans le capot 62 de façon à permettre un accès à la zone dans laquelle se trouve l'élément résonant 28.

Ensuite, comme l'illustre la figure 6B, on procède à un dépôt de façon à former une couche mince 66 au moins sur les parties apparentes de la couche 24 constituant l'élément 28, en particulier sur les parois des cavités débouchantes 36. La couche mince 66 est similaire à la couche 50 du mode de réalisation précédent et obéit aux mêmes contraintes de dépôt. Dans le cas où la couche 66 est formée par le dépôt conforme, la couche 66 comporte des portions de couche 68 sur le capot 62 et des portions de couche 70 sur la couche 20, comme cela est illustré en pointillés. Ces portions de couche 68 et 70 sont sans incidence sur le fonctionnement du dispositif si le matériau de la couche 66 est isolant. Par contre, s'il est conducteur, le mode de dépôt de la couche 66 sera choisi de façon à éviter la formation des portions de couche 68 et 70 pour exclure la formation d'un court-circuit entre les ancrages 26 et les électrodes 30 et 32.

Le procédé se poursuit, comme l'illustre la figure 6C, par le dépôt d'un matériau de scellement 72 propre à former des bouchons 74 aux emplacements des ouvertures 64 de façon à sceller le capot 62. Le procédé s'achève par des étapes de formation de contacts avec les ancrages 26 et les électrodes 30 et 32.

Selon une variante, les secondes étapes commencent par la mise en place du capot 62 et ce n'est qu'après que l'étape de test est mise en oeuvre. Pour ce faire, des ouvertures sont formées dans le capot 62 au niveau des électrodes 30, 32 et des ancrages 26. Une fois le test effectué, les ouvertures 64 sont formées, la couche 66 déposée et le capot 62 scellé par la couche 72.

Un avantage des procédés de fabrication proposés est qu'ils utilisent un substrat sur isolant SOI standard dans lequel l'épaisseur de l'isolant 22 est comprise entre 100 nm et 3 µm, typiquement de l'ordre de 1 µm. De même, toutes les couches utilisées présentent des dimensions compatibles avec les filières technologiques standard.

Un autre avantage est que la plage de correction possible est beaucoup plus étendue et précise qu'avec les solutions connues et ce sans recourir à des dispositifs complexes.

Un autre avantage est que la correction peut être effectuée aussi bien avant qu'après la mise en place d'un capot. En particulier, si une dérive de la fréquence nominale est susceptible d'apparaître en raison de traitements thermiques liés à la mise en place d'un capot, cette dérive peut être compensée après la mise en boîtier.

A titre d'exemple, les dimensions et natures des différentes couches sont les suivante :
- la plaquette 20 est une plaquette de silicium monocristallin, par exemple d'une épaisseur comprise entre 300 et 720 µm ;
- l'isolant 22 est une couche d'oxyde de silicium d'une épaisseur comprise entre 100 nm et 3 µm, par exemple de 1 µm ;
- la couche 24 est une couche de silicium monocristallin d'une épaisseur comprise entre 1 et 20 µm, par exemple de 3 µm ; au moins dans la zone de formation de l'élément 28, la couche 24 est poreuse, les pores étant par exemple traversants et d'un diamètre de 10 nm à 1 µm ;
- les cavités débouchantes 36 ont une largeur ou un diamètre d'au plus 1 µm ; de préférence, la largeur des ouvertures est réduite à la valeur minimale possible en fonction des procédés de gravure de la couche 24 ; le nombre de cavités 36 est tel qu'une proportion de 0,25 à 40 % de la masse de la portion de la couche 24 constituant l'élément 28 est retirée ; on notera que dans le cas où l'élément 28 comporte des colonnes d'un matériau ayant un coefficient de variation du module de Young du signe opposé à celui du matériau constituant la couche 24, les cavités 36 sont formées en-dehors de ces colonnes ; et
- la couche 50 ou 66 a alors une épaisseur comprise entre 0 et 500 nm.

La couche 50 ou 66 est par exemple constituée du même matériau semiconducteur que la couche 24 ou d'un autre matériau semiconducteur déposable sur la couche 24 par épitaxie, par exemple, du silicium, du germanium ou du silicium-germanium. Il peut également s'agir d'un matériau conducteur tel que le ruthénium, l'iridium, le platine ou le séléniure de zinc. La couche 50 ou 66 peut également être une couche isolante par exemple une couche d'oxyde métallique - tel qu'un oxyde d'aluminium, de silicium, de titane, de zinc ou d'hafnium - ou une couche de nitrure de silicium, de titane, de tantale, de tungstène ou de niobium, ou encore une couche isolante d'oxynitrure de silicium ou de sulfure de zinc.

Si la portion de la couche 24 constituant l'élément 28 est poreuse, le matériau choisi pour former la couche 50 ou 66 est de préférence propre à être déposé dans les pores sans les boucher, par exemple par épitaxie ou par un procédé du type dépôt par couche atomique (ALD).

Des modes de réalisation particuliers de la présente invention ont été décrits. Diverses variantes et modifications apparaîtront à l'homme de l'art. Ainsi, l'homme de l'art comprendra que la présente invention a été décrite dans le cas d'une technologie silicium. Toutefois, la couche 24 peut être réalisée en un autre matériau semiconducteur monocristallin ou polycristallin. En particulier, la couche 24 peut être une couche contrainte de silicium-germanium, une couche de germanium ou de tout autre matériau ou alliage semiconducteur tel que de l'arséniure de gallium. La couche 24 peut également être en un matériau semiconducteur à large bande interdite tel que du carbure de silicium (SiC) ou du carbone diamant.

La couche 24 ou à tout le moins sa portion dans laquelle est formé l'élément résonant 28 peut être en une forme poreuse de l'un des matériaux cités précédemment. Selon un mode de réalisation, au moins une partie des pores sont traversants. Par exemple, la couche 24 est en silicium mésoporeux ou macroporeux dont les pores ont un diamètre de 100 nm à 1 µm.

La structure de l'élément résonant n'est pas limitée à la forme rectangulaire représentée. L'élément résonant peut être une plaque fixée à au moins un ancrage par un bras. De préférence, les cavités débouchantes s'étendent alors radialement selon la direction d'extension/compression de l'élément. Elles sont régulièrement réparties à l'extérieur d'une zone d'exclusion périphérique centrée sur le noeud de vibration constitué par le centre géométrique de la plaque.

De façon similaire, l'élément résonant peut être un disque constitué d'un corps semiconducteur monocristallin. Les tranchées sont alors réparties autour du noeud constitué par le centre du disque. Les cavités sont disposées radialement de façon que leur éventuelle plus grande dimension en vue de dessus soit parallèle à la direction de propagation des ondes de volume en évitant une zone d'exclusion périphérique.

Ainsi, le résonateur peut comporter un élément ayant des formes très variées. L'homme de l'art saura adapter la position des cavités selon ce qui a été décrit précédemment de façon qu'elles s'étendent, en dehors d'une zone d'exclusion périphérique, symétriquement autour d'un noeud ou d'une ligne neutre de vibration. De préférence, les cavités s'étendent radialement selon la direction de propagation des ondes de volume.

Le résonateur peut également être formé en un matériau non semiconducteur mais devra être au moins partiellement conducteur.

Lorsque des dimensions ont été indiquées, elles l'ont été dans le cadre d'une filière technologique donnée. L'homme de l'art saura adapter les dimensions des différents éléments en fonction des contraintes de fabrication.

L'homme de l'art saura également former des cavités partiellement ou totalement remplies dans tout type de résonateur.

L'homme de l'art saura également compléter le cas échéant le procédé par des étapes couramment mises en oeuvre. Ainsi, au lieu d'utiliser comme électrodes les parties 30 et 32 du substrat en regard de l'élément 28, l'homme de l'art saura développer des électrodes s'appuyant sur ces portions du substrat avec réservation d'un intervalle vide entre les électrodes et l'élément 28. Les portions du substrat peuvent alors être utilisées comme simple support ou pour prendre des contacts d'électrode. Le cas échéant, les électrodes peuvent surplomber une faible partie périphérique de l'élément 28.

Par ailleurs, on a considéré dans la description précédente que le corps de l'élément résonant est constitué au moins partiellement d'un matériau conducteur. Dans ce cas le corps est directement polarisable et joue le rôle d'actionneur et/ou de détecteur. Toutefois, l'homme de l'art saura utiliser un corps en un matériau non conducteur en lui associant un actionneur et/ou un détecteur.

En outre, l'homme de l'art saura adapter les matériaux utilisés à une filière de fabrication donnée.

De plus, la présente invention a été décrite appliquée aux résonateurs à ondes de volume. Toutefois, la formation dans le corps d'un microsystème de cavités débouchantes, traversantes ou non traversantes, éventuellement partiellement ou totalement remplies par un matériau propre à compenser une dérive en fréquence, peut être utilisée dans tous les autres types de résonateurs tels que des résonateurs à mode de flexion et de façon plus générale dans tout type de microsystème.

## Revendications

1. Procédé d'ajustement de la fréquence de résonance d'un résonateur à ondes de volume comprenant un élément résonant (28), dans lequel l'élément résonant est constitué au moins en partie d'un corps constitué au moins en partie d'un premier matériau conducteur, le corps comportant des cavités (36) débouchantes, ce procédé comprenant les étapes successives suivantes :
mesure de la fréquence du résonateur ; et ensuite
remplissage au moins partiel desdites cavités par un deuxième matériau (50,66) pour ajuster la fréquence de résonance,
**caractérisé en ce que** le premier matériau conducteur est poreux, au moins certaines des cavités étant constituées par des pores débouchants.

2. Procédé selon la revendication 1, dans lequel au moins certaines des cavités débouchantes (36) sont des puits creusés au moins dans une partie de l'épaisseur de l'élément résonant (28).

3. Procédé selon la revendication 1 ou 2, dans lequel l'étape de remplissage est effectuée après la mise en place d'un capot (62).

4. Procédé selon l'une quelconque des revendications 1 à 3, dans lequel le matériau de remplissage (50 ; 66) des cavités (36) est choisi parmi le silicium, le germanium, le silicium-germanium, le ruthénium, l'iridium, le platine, le séléniure de zinc, l'oxyde de silicium, les oxydes d'aluminium, de titane, de zinc, d'hafnium, le nitrure de silicium, les nitrures de titane, de tantale, de tungstène, de niobium, l'oxynitrure de silicium et le sulfure de zinc.

5. Procédé selon l'une quelconque des revendications 1 à 4, comprenant en outre une étape de formation, dans le corps, de colonnes d'un matériau ayant un module d'Young dont le coefficient de température est d'un signe opposé à celui du premier matériau.

6. Résonateur à ondes de volume comprenant un élément résonant (28) comportant un corps constitué au moins en partie d'un premier matériau conducteur, le corps comportant des cavités débouchantes (36), les cavités étant au moins partiellement remplies d'un second matériau (50 ; 66),
**caractérisé en ce que** le premier matériau conducteur est poreux, au moins certaines des cavités étant constituées par des pores débouchants.

7. Résonateur selon la revendication 6, dans lequel le corps comporte des colonnes d'un matériau dont le coefficient de variation du module d'Young en fonction de la température est du signe opposé à celui du premier matériau.

## Claims

1. A method for adjusting the resonance frequency of a bulk-mode resonator comprising a resonant element (28), wherein the resonant element is at least partly formed of a body at least partly formed of a first conductive material, the body comprising open cavities (36), the method comprising the steps of:
measuring the resonator frequency; and
at least partially filling said cavities by a second material for adjusting the resonance frequency,
**characterized in that** the first conductive material is porous, at least some of the cavities (36) being formed by open pores.

2. The method of claim 1, wherein at least some of the open cavities (36) are wells dug at least in a portion of the thickness of the resonant element (28).

3. The method of claim 1 or 2, wherein the filling step is performed after a cap (62) has been installed.

4. The method of any of claims 1 to 3, wherein the material (50; 66) for filling the cavities (36) is selected from among silicon, germanium, silicon-germanium, ruthenium, iridium, platinum, zinc selenide, silicon oxide, oxides of aluminum, of titanium, of zinc, and of hafnium, silicon nitride, nitrides of titanium, of tantalum, of tungsten, and of niobium, silicon oxynitride, and zinc sulfide.

5. The method of any of claims 1 to 4, further comprising a step of forming, in the body, columns of a material having a Young's modulus with a temperature coefficient of a sign opposite to that of the first material.

6. A bulk-mode resonator comprising a resonant element (28) comprising a body at least partly formed of a first conductive material, the body comprising open cavities (36), the cavities being at least partially filled with a second material (50; 66),
**characterized in that** the first conductive material is porous, at least part of the cavities being formed of open pores.

7. The resonator of claim 6, wherein the body comprises columns of a material having a variation coefficient of its Young's modulus according to temperature of a sign opposite to that of the first material.

## Patentansprüche

1. Verfahren zum Einstellen der Resonanzfrequenz eines Bulk-Modus-Resonators, der ein Resonanzelement (28) aufweist, wobei das Resonanzelement wenigstens teilweise durch einen Körper gebildet wird, der wenigstens teilweise aus einem ersten leitendem Material ausgebildet ist, wobei der Körper offene Räume bzw. Hohlräume (36) aufweist, wobei das Verfahren folgende Schritt aufweist:
Messen der Resonanzfrequenz; und
wenigstens teilweises Füllen der Hohlräume durch ein zweites Material zum Einstellen der Resonanzfrequenz,
**dadurch gekennzeichnet, dass** das erste leitende Material porös ist,
wobei wenigstens einige der Hohlräume (36) durch offene Poren gebildet werden.

2. Verfahren nach Anspruch 1, wobei wenigstens einige der offenen Hohlräume (36) Gruben sind, welche in wenigstens einem Teil der Dicke des Resonanzelements (28) ausgebildet bzw. hineingegraben sind.

3. Verfahren nach Anspruch 1 oder 2, wobei der Füllschritt durchgeführt wird, nachdem eine Kappe (62) installiert wurde.

4. Verfahren nach einem der Ansprüche 1 bis 3, wobei das Material (50; 66) zum Füllen der Hohlräume (36) ausgewählt ist aus: Silizium, Germanium, Silizium-Germanium, Ruthenium, Iridium, Platin, Zinkselenit, Siliziumoxid, Oxiden aus: Aluminium, Titan, Zink und Hafnium, Siliziumnitird, Nitriden aus: Titan, Tantal, Wolfram und Niob, Siliziumoxynitrid und Zinksulfid.

5. Verfahren nach einem der Ansprüche 1 bis 4, das ferner einen Schritt des Ausbildens in dem Körper von Säulen aus einem Material mit einem Youngs-Modul mit einem Temperaturkoeffizienten mit einem entgegengesetzten Vorzeichen zu dem des ersten Materials aufweist.

6. Bulk-Modus-Resonator, der ein Resonanzelement (28) aufweist, das einen Körper aufweist, der wenigstens teilweise aus einem ersten leitenden Material ausgebildet ist, wobei der Körper offene Hohlräume (36) aufweist, wobei die Hohlräume wenigstens teilweise mit einem zweiten Material (50; 66) gefüllt sind, **dadurch gekennzeichnet, dass** das erste leitende Material porös ist, und wenigstens ein Teil der Hohlräume aus offenen Poren gebildet wird.

7. Resonator nach Anspruch 6, wobei der Körper Säulen aus einem Material mit einem Variationskoeffizienten seines Youngs-Moduls gemäß der Temperatur mit einem entgegengesetzten Vorzeichen zu dem des ersten Materials aufweist.
